# EUROPEAN PATENT SPECIFICATION

(11) **EP 0 516 248 B1**
(45) Date of publication and mention of the grant of the patent: **18.09.1996**
(21) Application number: 92202490.6
(22) Date of filing: 02.05.1989
(51) Int. Cl.: C23C 28/00, C23C 30/00, C23C 14/06, C23C 14/12

(54) **Multilayered film**
Mehrfachschicht
Film à couches multiples

(30) Priority: 02.05.1988 JP 109479/88; 02.05.1988 JP 109480/88
(43) Date of publication of application: 02.12.1992
(62) Divisional of application: 89304375.2
(73) Proprietor: ORIENT WATCH CO., LTD., Tokyo (JP); Murayama, Youichi, Shinjyuku-ku, Tokyo (JP)
(72) Inventor: Murayama, Youichi, Shinjyuku-Ku, Tokyo (JP)
(74) Representative: Calamita, Roberto

(56) References cited:
- EP-A- 0 069 701
- EP-A- 0 195 117
- DD-A- 260 524
- FR-A- 2 443 926
- US-A- 4 374 717

## Description

The present invention relates to a multilayered film. More particularly, the present invention relates to a composite film comprising a metal, an alloy and/or an inorganic substance together with an organic polymer film layer formed by vapour phase exciting deposition of a polycarbonate, polyacrylate and/or polyester on a substrate. The film has excellent decorative, protective and functional properties.

A widely utilized procedure is the formation of a vapour-deposited thin film of a metal, an inorganic material or an organic polymer on the surface of a substrate comprising a metal, glass, ceramic material or plastics material, the thus-formed thin film being used as an insulating film, a reflecting film, an optical thin film, a display element or an electronic device. Known processes for depositing such a thin film on a substrate include vacuum vapour deposition, sputtering, ion plating, CVD, MOCVD, MBE, etc.

US-A-4 374 717 discloses the improved adhesion of sputtered chromium or chromium metal alloys to urethane substrates by the application of plasma polymerized acetronitrile coating layers directly beneath and over the chromium layer.

However, there are problems with these conventional methods. There are problems in preparing thin films having the desired properties and functions, and therefore the uses of thin films are at present limited.

One problem is that a conventional film which is excellent in colour tone, corrosion resistance, adhesion, wear resistance and other functional properties, and which is applicable as a useful surface material for watches and accessories has not as yet been achieved. Furthermore, in order to form such a film using a conventional method, it is necessary to prepare a layer comprising an expensive metal or an alloy thereof, thus resulting in difficulty in preparing a composite film excellent in decorative property, protection and functionality and which may be manufactured at a low cost.

The present invention proposes means to solve these problems by forming a multilayered film comprising a metal, an alloy and/or an inorganic substance together with an organic polymer film layer formed by vapour phase exciting deposition of a polycarbonate, polyacrylate and/or polyester on a substrate. That is to say, the present invention provides a multilayered film comprising a thin film comprising a metal, an alloy, and/or an inorganic substance, and an organic polymer film layer formed by vapour phase plasma exciting deposition of a polycarbonate, polyacrylate and/or polyester on a substrate.

As the metal or the alloy in the composite compound film of the present invention, gold and/or at least one metal selected from Cu, Al, Ni, Ag, Zn, Sn, Ta, V, Cr, Co, Pt, Pd, Ru, Rh, Ti, W, Mo, Ir, Cd, Sb, Hf, Ga, Si, Fe, Y, Ba, Ge, Zr, Nb and In or an alloy thereof may be used. As the inorganic substance, TiN, TaN, ZrN, TaC, VN and/or C may be employed.

Depending upon the material of the substrate on which the film is to be formed, an undercoat comprising a metal, an alloy and an inorganic substance may be formed on the surface of the substrate, and further a composite film may be stacked thereon integrally therewith.

It is also possible to arrange a film as described above on the surface of a substrate, and stack an outer coat comprising a metal, an alloy and an inorganic substance thereon integrally therewith.

Methods applicable for forming such a film include a technique of evaporating a metal, an alloy, and/or an inorganic substance, simultaneously exciting the evaporated particles, and causing vapour-deposition in the state of ionized particles, neutral particles or radicals, and a method of sputtering, without excitation, etc. In terms of colour tone and adhesion strength, it is desirable to integrally form the film in the excited state.

In this case, evaporated particles should preferably be excited in a vacuum reactor by glow discharge and be plasma-ionized particles. The methods applicable for plasma-ionization include ion-plating processes such as the hollow cathode method and high-frequency excitation, and plasma CVD. For the organic polymer film layer it is also possible to use the method of polymer evaporation or introduction of monomer gas and vapour-depositing it through plasma polymerization.

For excitation, light radiation such as a laser beam may be applied. In using the ion-plating method, an inert gas such as argon may be introduced into a vacuum reactor, for example, maintained in a vacuum at a pressure of from 10⁻² to 10⁻⁵ Torr (1.33 to 1.33 x 10⁻³ Pa). The temperature of the substrate may be within the range of from room temperature to about 400°C. A reactive gas such as oxygen, nitrogen, ammonia, hydrogen carbide, hydrogen sulfide, or hydrogen fluoride may be introduced for vapour deposition by reactive ion-plating. In this case, the gas pressure should preferably be at least 10⁻⁴ Torr (1.33 x 10⁻² Pa).

By the present invention, as described above, it is possible to achieve a multilayered film excellent in colour tone, having a satisfactory adhesion strength and having such functional properties as dielectric property, conductivity and light response.

In the present invention, the multilayered film may, for example, be formed by vapour-depositing an organic polymer film on the surface of a substrate comprising a metal, an alloy, ceramics or plastics, and then sequentially forming a thin film comprising a metal, an alloy and/or an inorganic substance, and an organic polymer layer, or formed by vapour-phase depositing a thin film comprising a metal, an alloy and/or an inorganic substance, then an organic polymer film, and subsequently, a thin film comprising a metal, an alloy and/or an inorganic substance.

The thin film comprising a metal, an alloy and/or an inorganic substance in the present invention may, for example, be gold, a gold alloy or TiN, and not limited to these examples, a metal, an alloy or an inorganic substance having the desired colour tone and gloss. Examples of the metal or the alloy used in the present invention include such elements as gold, Cu, Al, Ni, Ag, Zn, Sn, Ta, V, Cr, Co, Pt, Pd, Ru, Rh, Ti, W, Mo, Ir, Cd, Sb, Hf, Ga, Si, Fe, Y, Ba, Ge, Zr, Nb and In or an inorganic substance comprising a compound thereof such as TiN, TaN, ZrN, TaC, VN and/or C.

The organic polymer is present as a separate film which is a thin film of polycarbonate, polyacrylate, and/or polyester. A dye compound or a pigment could be vapour-deposited for colouring.

There is no particular limitation for the substrate, which may be a glass, a metal, an alloy, a ceramic material or a plastics material.

The thin film comprising a metal, an alloy and/or an inorganic substance and the organic polymer film as listed above may be formed by plasma-exciting particles produced through evaporation of the material and vapour-depositing the resultant ionized particles, neutral particles or radicals. It is also possible to form a thin film of metal or alloy, not by excitation, but by sputtering, etc. However, with a view to largely improving the colour tone, adhesion strength and wear resistance of the composite multilayered film, it is desirable to integrally form it by plasma excitation.

The evaporated particles should preferably be excited by glow discharge in a vacuum reactor for plasma ionization. Means for plasma ionization convenient in this case include ion plating such as the hollow cathode method and the high-frequency excitation method, and plasma CVD. When forming the organic polymer film, plasma excitation may be applied by evaporating the polymer or introducing a monomer gas for vapour deposition. Laser beam excitation may also be applied.

When applying the ion plating method, an inert gas such as argon could be introduced into a vacuum reactor kept in vacuum at a pressure of, for example, from 10⁻² to 10⁻⁵ Torr (1.33 to 1.33 x 10⁻³ Pa). The substrate temperature may be within the range of from room temperature to about 400°C. When forming an inorganic thin film, vapour deposition could be preferably carried out by ion plating through introduction of a reactive gas such as oxygen, nitrogen, ammonia, hydrogen carbide, hydrogen sulfide, or hydrogen fluoride. In this case, the gas pressure should preferably be at least 10⁻⁴ Torr (1.33 x 10⁻² Pa).

By the present invention, as described above, it is possible to achieve a low-cost film excellent in colour tone, having a satisfactory adhesion strength, and having such functional properties as dielectric property, conductivity and light response.

The present invention will now be illustrated by means of the following non-limiting Examples.

In the following examples reference will be made to the accompanying drawings in which:

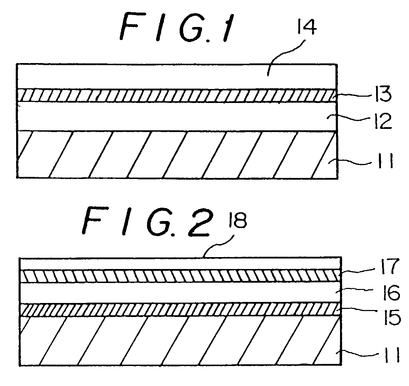

Figs. 1 and 2 are sectional views illustrating typical multilayered films of the present invention.

### Example 1

A multilayered film was formed by an ion plating apparatus based on high-frequency excitation. As shown in Fig. 1, a stainless steel sheet was used as the substrate (11).

The stainless steel sheet was bombarded by introducing argon gas under conditions of up to a pressure of 5 x 10⁻⁵ Torr (6.67 x 10⁻³ Pa), and then, a TiN thin film (12) was vapour-deposited by reactive ion plating with nitrogen gas and evaporated Ti particles under a pressure of 8 x 10⁻⁴ Torr (0.11 Pa). A 0.2 micrometre-thick TiN thin film (12) was formed through reaction for three minutes under conditions including a discharge power of 300 W and a substrate temperature of 100°C.

A polymer film (13) was vapour-deposited by plasma-ionizing evaporated particles of polycarbonate under an argon pressure of 4 x 10⁻³ Torr (0.53 Pa). Then, a gold thin film (14) was formed through plasma-ionization of evaporated gold particles under an argon pressure of 3 x 10⁻³ Torr (0.40 Pa).

This resulted in a multilayered film excellent in gold colour tone. All properties such as colour tone, adhesion strength and wear resistance were far superior to those available in the absence of an organic polymer film, and wear resistance was about twice as high.

### Example 2

A polycarbonate polymer film was vapour-deposited under an argon pressure of 4 x 10⁻³ Torr (0.53 Pa) on the surface of the multilayered film obtained in Example 1. A hard transparent polymer film was obtained, with a glossy gold colour tone giving an elegant appearance. The film had excellent surface protective properties.

### Example 3

A transparent polyacrylate polymer layer and a thin gold film were vapour-deposited on a glass substrate as in Example 1. The gold film showed a satisfactory colour tone and wear resistance was about twice as high as that available without vapour deposition of the polyacrylate polymer film.

### Example 4

Polycarbonate polymer film (17) and an ITO (transparent conductive substance) film (18) were sequentially vapour-deposited on the surface of the multilayered film comprising a polyacrylate polymer film (15) and a thin gold film (16) obtained in Example 1, as shown in Fig. 2. The resultant multilayered film had a colour tone of gold and a satisfactory surface conductivity (resistance: 200 Ω[]).

The ITO thin film was formed, with ITO as the evaporation source, under conditions including an oxygen pressure of 3 x 10⁻⁴ Torr (0.04 Pa), a discharge power of 300 W, and a substrate temperature of 30°C. It is a 0.3 micrometre-thick transparent conductive film.

As described above in detail, the present invention provides the following industrially useful effects:
1. It is possible to reduce the consumption of the metal, alloy or inorganic substance without changing the colour tone of the metal, the alloy or the inorganic substance used.
2. The film having an organic substance can have a frictional coefficient lower than that of a film formed from a metal, an alloy or an inorganic substance alone, and wear resistance can be improved over that of a film comprising only the material of the film.
3. In a film formed from a metal, an alloy or an inorganic substance alone, corrosion resistance may be affected by the occurrence of pinholes. In the film, in contrast, corrosion resistance can be largely improved.
4. The film as applied to an article in direct touch with human skin gives a lower sensation of coldness than when human skin touches a metal, an alloy or an inorganic substance. Moreover the film can prevent allergy to Ni ions, etc.
5. It is possible to provide the surface a film with conductivity, so that conductive films of various colour tones can be prepared.

These merits are particularly effective when applying the present invention to an accessory, a watch, glasses and other articles of utility, thus providing a very wide range of applications including display elements using various colour tones as part of the design thereof.

## Claims

1. A multilayered film comprising a thin film comprising a metal, an alloy, and/or an inorganic substance, and an organic polymer film layer formed by vapour phase plasma exciting deposition of a polycarbonate, polyacrylate and/or polyester on a substrate.

2. A multilayered film as claimed in claim 1, wherein said film has a layer comprising gold or its alloy, and an inorganic substance selected from TiN, TaN, ZrN, VN, TaC and/or C.

3. A multilayered as claimed in claim 1, wherein said film has a layer comprising gold and/or at least one metal selected from Cu, Al, Ni, Ag, Zn, Sn, Ta, V, Cr, Co, Pt, Pd, Ru, Rh, Ti, W, Mo, Ir, Cd, Sb, Hf, Ga, Si, Fe, Y, Ba, Ge, Zr, Nb and In, or an alloy thereof.

4. A multilayered film as claimed in claim 1, wherein said film includes an organic polymer layer as an intermediate layer.

## Patentansprüche

1. Mehrschichtfilm, umfassend einen dünnen Film, der ein Metall, eine Legierung und/oder einen anorganischen Stoff umfaßt und eine organische Polymerfilmschicht, gebildet durch Dampfphasen-Plasmaanregungs-Abscheidung eines Polycarbonats, Polyacrylats und/oder Polyesters auf einem Substrat.

2. Mehrschichtfilm nach Anspruch 1, wobei der Film aufweist: eine Schicht, umfassend Gold oder seine Legierung und einen anorganischen Stoff, ausgewählt aus TiN, TaN, ZrN, VN, TaC und/oder C.

3. Mehrschichtfilm nach Anspruch 1, wobei der Film aufweist: eine Schicht, umfassend Gold und/oder mindestens ein Metall, ausgewählt aus Cu, Al, Ni, Ag, Zn, Sn, Ta, V, Cr, Co, Pt, Pd, Ru, Rh, Ti, W, Mo, Ir, Cd, Sb, Hf, Ga, Si, Fe, Y, Ba, Ge, Zr, Nb und In, oder eine Legierung davon.

4. Mehrschichtfilm nach Anspruch 1, wobei der Film eine organische Polymerschicht als Zwischenschicht einschließt.

## Revendications

1. Film multicouche comprenant une fine pellicule comprenant un métal, un alliage, et/ou une substance minérale, et une couche d'un film polymère organique formée par dépôt en phase vapeur d'un polycarbonate, polyacrylate et/ou polyester sur un substrat par excitation d'un plasma.

2. Film multicouche selon la revendication 1, ledit film présentant une couche comprenant de l'or ou un de ses alliages, et une substance minérale choisie parmi TiN, TaN, ZrN, VN, TaC et/ou C.

3. Film multicouche selon la revendication 1, ledit film présentant une couche comprenant de l'or et/ou au moins un métal choisi parmi Cu, AI, Ni, Ag, Zn, Sn, Ta, V, Cr, Co, Pt, Pd, Ru, Rh, Ti, W, Mo, Ir, Cd, Sb, Hf, Ga, Si, Fe, Y, Ba, Ge, Zr, Nb et In, ou un alliage de ceux-ci.

4. Film multicouche selon la revendication 1, ledit film comprenant une couche d'un polymère organique en tant que couche intermédiaire.
